# EUROPÄISCHE PATENTANMELDUNG

(11) **EP 1 223 545 A2**
(43) Veröffentlichungstag der Anmeldung: **17.07.2002**
(21) Anmeldenummer: 02000658.1
(22) Anmeldetag: 11.01.2002
(51) Int. Cl.: G06K 19/073

(54) **Elektrische oder Elektronische Schaltungsanordnung und Verfahren zum Schützen der selben vor Manipulation und/oder vor Missbrauch**

(30) Priorität: 13.01.2001 DE 10101330
(71) Anmelder: Philips Corporate Intellectual Property GmbH, 52066 Aachen (DE); Koninklijke Philips Electronics N.V., 5621 BA Eindhoven (NL)
(72) Erfinder: Fuhrmann, Johann, Philips Corp. Intel. Prop. GmbH, 52066 Aachen (DE); Bretschneider, Ernst, Philips Cor. Int. Prop. GmbH, 52066 Aachen (DE); Einfeldt, Walter, Philips Corp. Intel. Prop. GmbH, 52066 Aachen (DE)
(74) Vertreter: Volmer, Georg, Dipl.-Ing.

(57) **Zusammenfassung**

Um eine elektrische oder elektronische Schaltungsanordnung (100), zu schaffen wird vorgeschlagen,
- dass an die Kontaktanschlüsse (22, 27) der integrierten Schaltung mindestens eine Signalerzeugungseinheit (40), insbesondere mindestens eine Oszillatoreinheit, angeschlossen ist, deren Ausgangsfrequenz (f_{meß}) im wesentlichen durch den spezifischen Kapazitätswert (C) bestimmt ist,
- dass der Signalerzeugungseinheit (40) mindestens eine erste, mit der Ausgangsfrequenz (f_{meß}) der Signalerzeugungseinheit (40) getaktete Zählereinheit (50) nachgeschaltet ist, in der nach einer vorgegebenen zeitlichen Zählperiode ein Istwert-Zählerstand ermittelbar ist,
- dass mindestens eine zweite, mit einer Referenzfrequenz (f_{ref}) getaktete Zählereinheit (55) vorgesehen ist, in der nach der vorgegebenen zeitlichen Zählperiode ein Sollwert-Zählerstand ermittelbar ist,
- dass der ersten Zählereinheit (50) und der zweiten Zählereinheit (55) mindestens eine Komparatoreinheit (60) zum Vergleichen des Istwert-Zählerstands mit dem Sollwert-Zählerstand nachgeschaltet ist, wobei die Funktionen der integrierten Schaltung bei Vorliegen einer beim Vergleichen des Istwert-Zählerstands mit dem Sollwert-Zählerstand auftretenden Fehlermeldung vorübergehend oder dauernd blockierbar und/oder sperrbar und/oder unterbrechbar sind.

## Beschreibung

Die vorliegende Erfindung betrifft eine elektrische oder elektronische Schaltungsanordnung, aufweisend
- mindestens ein insbesondere schichtförmiges Trägersubstrat aus halbleitendem oder isolierendem Material;
- mindestens eine durch mindestens zwei beabstandet zueinander auf dem Trägersubstrat insbesondere lithographisch aufgebrachte Leiterbahnen gebildete integrierte Schaltung,
- mindestens eine sich zwischen den Leiterbahnen und/oder lateral zu den Leiterbahnen und/oder auf den Leiterbahnen befindliche, zum Schützen der integrierten Schaltung vor äußeren Einflüssen vorgesehene dielektrische Abdeckung, insbesondere Isolierungsschicht und/oder Passivierungsschicht und/oder weitere Schutzschicht, so dass die integrierte Schaltung einen spezifischen, durch die dielektrische Abdeckung bestimmten, insbesondere lateralen und/oder insbesondere parasitären Kapazitätswert aufweist.

Die Erfindung betrifft des weiteren ein Verfahren zum Schützen einer derart ausgebildeten elektrischen oder elektronischen Schaltungsanordnung vor Manipulation und/oder vor Mißbrauch.

Generell gilt im Zusammenhang mit Schutz vor Manipulation und/oder vor Mißbrauch, dass die Sicherheitsanforderungen insbesondere auf dem Gebiet der Smart Card-Chiptechnik mit wachsender Verbreitung der Smart Cards laufend zunehmen, wie etwa aus dem Beispiel der Bankkarten, der Krankenkassenkarten oder auch diverser Sicherheitschipkarten ersehen werden kann. Die Gemeinsamkeit aller derartigen Chipkarten beruht auf der Speicherung sensibler Daten, die einzig und allein für den autorisierten, das heißt berechtigten Benutzer der Chipkarte im zuvor definierten Rahmen zugänglich sein sollen. In diesem Zusammenhang ist es in der Regel das Ziel unbefugter Personen, Informationen aus der Chipkarte zu lesen bzw. die funktionalen Bausteine des Chips zu analysieren, um die Chipkarte mißbräuchlich einsetzen zu können.

Eine manipulative Möglichkeit, unbefugt Informationen über den Aufbau und/oder die Funktion von Chipkarten zu erhalten, bietet das chemische oder mechanische Entfernen der dielektrischen Abdeckung, insbesondere der Passivierungsschicht, zum Zwecke der elektrischen oder elektronischen Analyse mittels Antastens der Leiterbahnen, etwa mit auf die Leiterbahnen aufzusetzenden (Meß-)Nadeln, und/oder zum Zwecke der optischen Analyse der funktionalen Bausteine mittels Mikroskop; auf diese Weise können nicht zuletzt auch durch Software definierte Schranken zumindest teilweise unbefugterweise überwunden werden. Um nun die aus diesen Mißbrauchsgefahren resultierenden Sicherheitsanforderungen erfüllen zu können, wird ein Konzept benötigt, das eine Kombination aus aktiven und passiven Sicherheitsstrukturen, wie etwa aus (Licht-)Sensoren und aus Passivierungsschichten, vereint.

Eine Anordnung der eingangs genannten Art ist nun durch die Druckschrift DE 197 38 990 A1 bekannt. Bei der in dieser Druckschrift offenbarten Einrichtung zum Schutz gegen Mißbrauch einer Chipkarte werden die dielektrischen Eigenschaften einer Passivierungsschicht auf dem Chip einer Chipkarte mittels eines durch die Passivierungsschicht beeinflußten Kapazitätswertes abgetastet. Hierzu wird ein Oszillator eingesetzt, dessen Schwingfrequenz durch den genannten Kapazitätswert bestimmt ist. Die aktuelle Schwingfrequenz wird mit einem Sollwert verglichen, indem ein Zähler über ein bestimmtes Zeitintervall getaktet wird und der Endzählerstand als Maß für die aktuelle Schwingfrequenz herangezogen wird.

Hierbei kann die vom Zähler bereitgestellte Zahl zusätzlich gemäß einem frei wählbaren Verknüpfungsalgorithmus mit einer personenspezifischen Zahl verknüpft werden, um eine weitere Zahl zu erhalten, und wahlweise kann die vom Zähler bereitgestellte Zahl oder die weitere Zahl mit einem Referenzwert verglichen werden.

Diese bekannte Anordnung impliziert zwar eine Reihe von Vorteilen, wie etwa die Möglichkeit, einen Mißbrauch durch Chipmanipulation mittels sensibler Kapazitätsabtastung an der Kapazitätsanordnung in der den Chip abdeckenden Schutzschicht aus Dielektrikum zu verhindern; gleichwohl entsteht der angestrebte "kapazitive Sensor" bei der Anordnung gemäß der Druckschrift DE 197 38 990 A1 erst nach Montage des zu schützenden Chips auf einer Karte mittels Aufbringens eines geeigneten Schutzlacks und ist auch nur auf diese Art und Weise funktionsfähig.

Ausgehend von diesen Nachteilen und Unzulänglichkeiten der konventionellen Anordnungen liegt der vorliegenden Erfindung die Aufgabe zugrunde, eine elektrische oder elektronische Schaltungsanordnung der eingangs genannten Art sowie ein Verfahren zum Schützen einer elektrischen oder elektronischen Schaltungsanordnung vor Manipulation und/oder vor Mißbrauch bereitzustellen, bei denen im Unterschied zum Stand der Technik eine vollständige Integration des angestrebten "kapazitiven Detektors" im (Halbleiter-) Chip ermöglicht ist, ohne dass - etwa über "Kontaktpads" - elektrische Verbindungen zur Außenwelt erforderlich wären und unabhängig davon, wie der (Halbleiter-) Chip letztendlich eingesetzt wird. Des weiteren sollen durch die vorliegende Erfindung aufwendige Montagearbeiten beim eigentlichen Hersteller der Chipkarten entfallen.

Diese Aufgabe wird durch die im Anspruch 1 für eine elektrische oder elektronische Schaltungsanordnung angegebenen Merkmale sowie durch die im Anspruch 12 für ein Verfahren zum Schützen einer elektrischen oder elektronischen Schaltungsanordnung vor Manipulation und/oder vor Mißbrauch angegebenen Merkmale gelöst. Vorteilhafte Ausgestaltungen und zweckmäßige Weiterbildungen der vorliegenden Erfindung sind in den jeweiligen Unteransprüchen gekennzeichnet.

Gemäß der Lehre der vorliegenden Erfindung kann durch den vorliegenden "kapazitiven Detektor", der auch als "Passivierungsschichtsensor" bezeichnet werden kann, eine manipulative Attacke auf eine durch mindestens zwei beabstandet zueinander auf einem Trägersubstrat insbesondere lithographisch aufgebrachte Leiterbahnen gebildete integrierte Schaltung verhindert, zumindest jedoch erschwert werden. In diesem Zusammenhang basiert das Konzept des vorliegenden "kapazitiven Detektors" oder "Passivierungsschichtsensors" auf der Ausnutzung lateraler parasitärer Kapazitäten, die sich durch die Nachbarschaft der mindestens zwei leitenden, in bevorzugter Weise voneinander unabhängigen Leiterbahnen ergeben.

Wird nun die mindestens eine zum Schützen der integrierten Schaltung vor äußeren Einflüssen vorgesehene dielektrische Abdeckung, insbesondere in Form mindestens einer Isolierungsschicht und/oder in Form mindestens einer Passivierungsschicht und/oder in Form mindestens einer weiteren Schutzschicht, in manipulativer und/oder mißbräuchlicher Absicht von einer hierzu nicht autorisierten, d.h. nicht berechtigten Person zumindest partiell entfernt, so ändert sich der relative Dielektrizitätswert der sich zwischen den Leiterbahnen und/oder lateral zu den Leiterbahnen und/oder auf den Leiterbahnen befindlichen Isolierungsschicht und/oder Passivierungsschicht und/oder weiteren Schutzschicht. Diese Änderung Δεᵣ des relativen Dielektrizitätswerts führt zu einer Änderung ΔC des spezifischen Kapazitätswerts gemäß der Formel ΔC = ε₀ · Δεᵣ · h · l/d, wobei durch
- ε₀ = 8,8542·10⁻¹² A s V⁻¹ m⁻¹ die Feldkonstante,
- h die Höhe der Leiterbahnen,
- l die Länge der Leiterbahnen und
- d der Abstand zwischen der ersten Leiterbahn und der zweiten Leiterbahn gegeben ist.

Hat mithin die Passivierungsschicht einen relativen Dielektrizitätswert εᵣ = 3,9 oder im Falle einer abdeckenden Siliziumnitritschicht gar von εᵣ = 7,5, so ändert sich dieser relative Dielektrizitätswert nach einem vollständigen Entfernen der Passivierungsschicht auf ε_{r,Luft} = 1, d.h. die lateralen parasitären Kapazitäten, die sich durch die Nachbarschaft der mindestens zwei leitenden, in bevorzugter Weise voneinander unabhängigen Leiterbahnen ergeben, ändern sich um einen hohen Faktor.

Die Auswertung dieser Kapazitätsänderung kann als Absolutmessung oder als Relativmessung erfolgen: Wird die laterale parasitäre Kapazität in eine geeignete Oszillatorschaltung, wie etwa in eine RC-Oszillatorschaltung oder auch in eine LC-Oszillatorschaltung, integriert, so kann durch Auswertung der Frequenzänderung infolge der Dielektrizitätsänderung gewissermaßen ein kapazitiver Sensor realisiert werden.

Eine differentielle Auswertung der vorstehend beschriebenen Kapazitätsänderung erfolgt in diesem Zusammenhang in zwei Schritten:

In einem ersten Schritt wird der durch mindestens zwei zweckmäßigerweise parallele Leiterbahnen gebildete, mit mindestens einer Passivierungsschicht bedeckte "Passivierungssensor" an mindestens eine Signalerzeugungseinheit, insbesondere an mindestens eine Oszillatoreinheit, angeschlossen. Die Kapazitätsänderung bewirkt hierbei eine Änderung der Oszillationsfrequenz.

In einem zweiten Schritt kommen nun mindestens zwei vorzugsweise digitale Zählereinheiten dergestalt zum Einsatz, dass eine erste Zählereinheit mit der Ausgangsfrequenz der Signalerzeugungseinheit getaktet wird, wohingegen eine zweite Zählereinheit mit einer Referenzfrequenz getaktet wird. Erreicht nun die erste Zählereinheit einen bestimmten vorgegebenen Wert, so wird der Zählerstand zwischen der ersten Zählereinheit und der zweiten Zählereinheit in mindestens einer Komparatoreinheit verglichen. Im Normalfall (dielektrische Abdeckung weder chemisch noch mechanisch angegriffen, geschweige denn entfernt, d.h. dielektrische Abdeckung in Ordnung) führt der Vergleich des Zählerstands zu keiner Fehlermeldung, im Manipulations- bzw. Mißbrauchsfall (dielektrische Abdekkung chemisch und/oder mechanisch angegriffen oder sogar entfernt, d.h. dielektrische Abdeckung nicht in Ordnung) wird aus der infolgedessen verschobenen Frequenz eine Fehlermeldung generiert.

Zusammenfassend läßt sich feststellen, dass durch die vorliegende Erfindung eine elektrische oder elektronische Schaltungsanordnung sowie ein Verfahren zum Schützen einer elektrischen oder elektronischen Schaltungsanordnung vor Manipulation und/oder vor Mißbrauch zur Verfügung gestellt wird, bei denen - in Abgrenzung zur Einrichtung gemäß der Druckschrift DE 197 38 990 A1 - eine vollständige Integration des angestrebten "kapazitiven Detektors" im (Halbleiter-)Chip ermöglicht ist, ohne dass - etwa über "Kontaktpads" - elektrische Verbindungen zur Außenwelt erforderlich sind und unabhängig davon, wie der (Halbleiter-) Chip letztendlich eingesetzt wird. Des weiteren entfallen durch die vorliegende Erfindung aufwendige Montagearbeiten beim eigentlichen Hersteller der Chipkarten.

Ein Ausführungsbeispiel der vorliegenden Erfindung wird nachstehend anhand der Zeichnungen näher erläutert. Es zeigt:
- Fig. 1: eine durch zwei beabstandet zueinander auf einem Trägersubstrat aufgebrachte Leiterbahnen gebildete integrierte Schaltung im Querschnitt; und
- Fig. 2: ein Ausführungsbeispiel einer Schaltungsanordnung gemäß der vorliegenden Erfindung in schematischer Prinzipdarstellung.

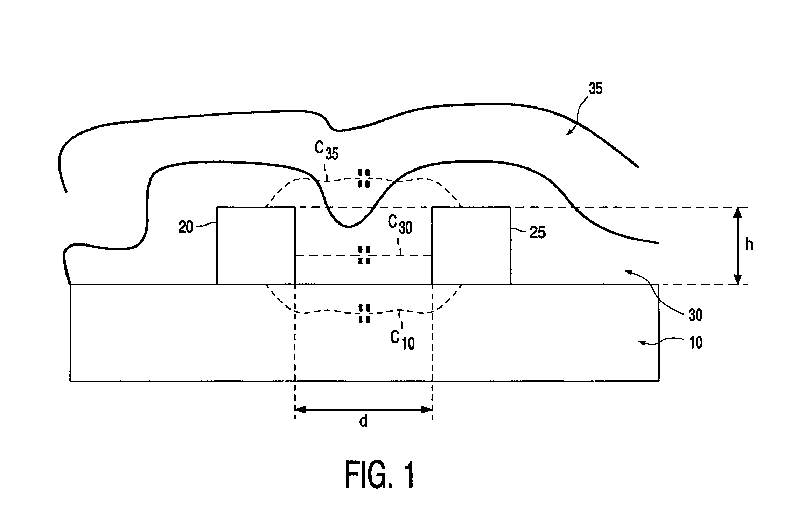

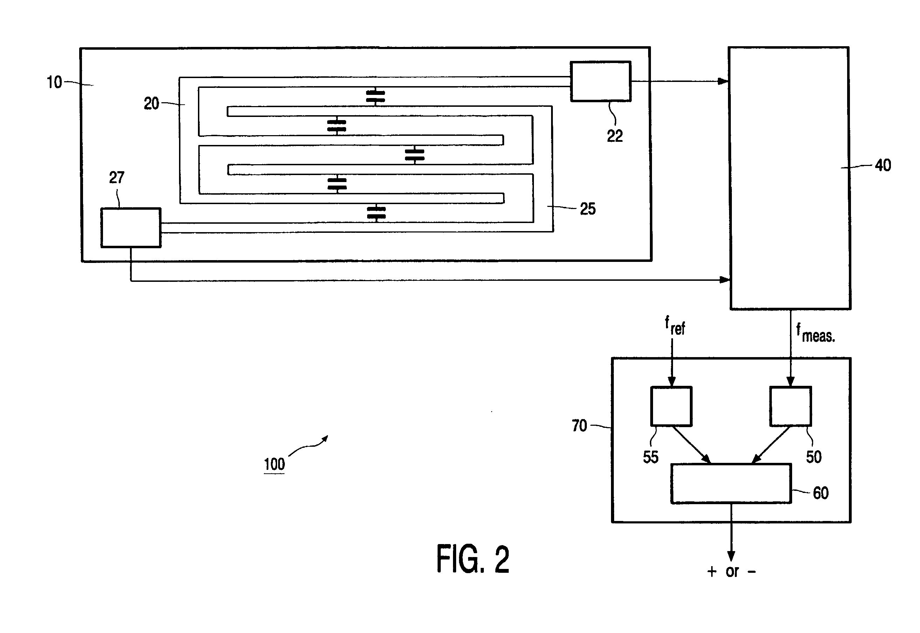

Gleiche oder ähnliche Ausgestaltungen, Elemente oder Merkmale sind in den Figuren 1 und 2 mit identischen Bezugszeichen versehen.

Die in Fig. 2 dargestellte, in eine Chipkarte oder Smart Card zu implementierende und /oder zu integrierende Schaltungsanordnung 100 weist, wie aus Fig. 1 im Querschnitt ersichtlich, ein schichtförmiges Trägersubstrat 10 aus halbleitendem Material einschließlich prozessierter Schaltungen und Leiterbahnen bis zur vorletzten Metallebene auf. Dementsprechend ist auf dem Trägersubstrat 10 eine durch zwei mit Abstand d zueinander (Größenordnung des Abstands d im Mikrometerbereich) lithographisch aufgebrachte, abschnittsweise parallel zueinander und meanderartig ineinandergreifend angeordnete Leiterbahnen 20, 25 gebildete integrierte Schaltung angeordnet, wobei zwischen den Leiterbahnen 20, 25 und lateral zu den Leiterbahnen 20, 25 eine erste dielektrische Abdeckung in Form einer Passivierungsschicht 30 zum Schützen der integrierten Schaltung vor äußeren Einflüssen angeordnet ist (vgl. Fig. 1).

Des weiteren ist auf den Leiterbahnen 20, 25 eine ebenfalls zum Schützen der integrierten Schaltung vor äußeren Einflüssen vorgesehene dielektrische Abdeckung in Form einer weiteren Schutzschicht 35 vorgesehen, so dass die integrierte Schaltung einen spezifischen, im wesentlichen durch die beiden aus lichtundurchlässigem Material gebildeten dielektrischen Abdeckungen 30, 35 bestimmten lateralen parasitären Kapazitätswert C = C₁₀ + C₃₀ + C₃₅ aufweist (C₁₀ ist der spezifische Kapazitätswert des Trägersubstrats 10).

Wird nun eine oder werden beide dielektrischen Abdeckungen in Form der Passivierungsschicht 30 und in Form der weiteren Schutzschicht 35 zumindest partiell entfernt, so ändert sich der relative Dielektrizitätswert der sich zwischen den Leiterbahnen 20, 25, lateral zu den Leiterbahnen 20, 25 und auf den Leiterbahnen 20, 25 befindlichen dielektrischen Abdeckungen.

Da nun an die Kontaktanschlüsse 22 bzw. 27 der Leiterbahnen 20 bzw. 25 eine Signalerzeugungseinheit 40 in Form einer Oszillatoreinheit (= Schwingkreis aus einer kapazitiven Einheit, nämlich einem Kondensator, und aus einer resistiven Einheit, nämlich einem Widerstand) angeschlossen ist, deren Ausgangsfrequenz f_{meß} durch den spezifischen Kapazitätswert C = C₁₀ + C₃₀ + C₃₅ bestimmt ist, wirkt sich die durch die Änderung des relativen Dielektrizitätswerts Δεᵣ bedingte spezifische Kapazitätsänderung ΔC = ε₀·Δεᵣ·h·l/d unmittelbar auf die in der Signalerzeugungseinheit 40 generierte Ausgangsfrequenz f_{meß} aus.

In Bezug auf diese Signalerzeugungseinheit 40 in Form der RC-Oszillatoreinheit wird gewährleistet, dass die Signalerzeugungseinheit 40 in einem breiten Spannungs- und Temperaturbereich bei niedrigem Stromverbrauch sicher arbeitet.

Als Referenzfrequenz f_{ref} kann die zum Betrieb des Chips notwendige Systemfrequenz benutzt werden. Eine weitere Möglichkeit bietet die Benutzung eines zusätzlichen Oszillators, dessen Aufbau dem Oszillator der Meßfrequenz identisch ist, dessen frequenzbestimmenden Elemente allerdings in einer anderen Isolatorschicht untergebracht sind.

Ein wesentlicher Vorteil der Signalerzeugungseinheit 40 in Form der RC-Oszillatoreinheit ist in dem großen Spannungs- und Temperaturbereich zu sehen, in dem die RC-Oszillatoreinheit arbeitet. Entfernt man den vorliegenden "kapazitiven Detektor", der auch als "Passivierungsschichtsensor" bezeichnet werden kann, so bricht nicht etwa die Oszillation ab oder schwingt mit unendlich großer Frequenz, sondern erhöht sich lediglich auf ein Mehrfaches der vorherigen Normalfrequenz.

Der Signalerzeugungseinheit 40 ist eine erste, mit der Ausgangsfrequenz f_{meß} der Signalerzeugungseinheit 40 getaktete digitale Zählereinheit 50 nachgeschaltet (vgl. Fig. 2), in der nach einer vorgegebenen zeitlichen Zählperiode ein Istwert-Zählerstand ermittelbar ist. Des weiteren ist in der Schaltungsanordnung 100 eine zweite, mit einer Referenzfrequenz f_{ref} getaktete digitale Zählereinheit 55 vorgesehen, in der nach der vorgegebenen zeitlichen Zählperiode ein Sollwert-Zählerstand ermittelbar ist.

In der der ersten Zählereinheit 50 und der zweiten Zählereinheit 55 nachgeschalteten Komparatoreinheit 60 wird dann der Istwert-Zählerstand mit dem Sollwert-Zählerstand verglichen, wobei die Funktionen der integrierten Schaltung bei Vorliegen einer beim Vergleichen des Istwert-Zählerstands mit dem Sollwert-Zählerstand auftretenden Fehlermeldung vorübergehend oder dauernd blockierbar und/oder sperrbar und/oder unterbrechbar sind (siehe Symbol "-" in Fig. 2; bei Ausbleiben einer Fehlermeldung: Symbol "+" in Fig. 2), denn in diesem Falle liegt infolge eines manipulativen und/oder mißbräuchlichen Angriffs auf die abdeckenden Dielektrika gemäß den vorstehend beschriebenen Zusammenhängen eine Änderung des relativen Dielektrizitätswerts, d.h. eine Kapazitätsänderung, d.h. eine Frequenzverschiebung vor.

Wie Fig. 2 ebenfalls entnehmbar ist, ist durch die erste Zählereinheit 50, durch die zweite Zählereinheit 55 und durch die Komparatoreinheit 60 eine differentielle Auswerteeinheit 70 gebildet. Diese differentielle Auswerteeinheit 70 ist demzufolge zum Feststellen der durch ein zumindest partielles Entfernen der dielektrischen Abdeckungen 30, 35 bedingten Änderung des spezifischen Kapazitätswerts C ausgelegt, wobei die Auswerteeinheit 70 die Fehlermeldung im speziellen dann generiert, wenn der Istwert vom Sollbereich abweicht.

Zur praktischen Realisierung der Schaltungsanordnung 100 gemäß der vorliegenden Erfindung sei abschließend noch angemerkt, dass die Größe des spezifischen Kapazitätswerts C von der angestrebten Oszillatorfrequenz f_{meß} abhängig ist, wobei die Berechnung des lateralen parasitären Kapazitätswerts C auf dem in Fig. 1 und 2 angedeuteten Ersatzschaltbild basiert. So hat sich beispielhaft gezeigt, dass sich im Layout bei Abständen d der Leiterbahnen 20, 25 von etwa zwei Mikrometern eine laterale Kapazität von etwa 29,7·10⁻¹² F m⁻¹ ergibt.

### BEZUGSZEICHENLISTE

- 100: elektrische oder elektronische Schaltungsanordnung
- 10: Trägersubstrat
- 20: erste Leiterbahn
- 22: Kontaktanschluss der ersten Leiterbahn 20
- 25: zweite Leiterbahn
- 27: Kontaktanschluss der zweiten Leiterbahn 25
- 30: erste dielektrische Abdeckung, insbesondere Passivierungsschicht
- 35: zweite dielektrische Abdeckung, insbesondere weitere Schutzschicht
- 40: Signalerzeugungseinheit, insbesondere Oszillatoreinheit
- 50: erste Zählereinheit
- 55: zweite Zählereinheit
- 60: Komparatoreinheit
- 70: Auswerteeinheit
- C: spezifischer Kapazitätswert
- ΔC: Änderung des spezifischen Kapazitätswerts
- C₁₀: spezifischer Kapazitätswert des Trägersubstrats 10
- C₃₀: spezifischer Kapazitätswert der ersten dielektrischen Abdeckung 30
- C₃₅: spezifischer Kapazitätswert der zweiten dielektrischen Abdeckung 35
- d: Abstand zwischen der ersten Leiterbahn 20 und der zweiten Leiterbahn 25
- ε₀: Feldkonstante (□₀ = 8,8542·10⁻¹² A s V⁻¹ m⁻¹)
- εᵣ: relativer Dielektrizitätswert
- Δεᵣ: Änderung des relativen Dielektrizitätswerts
- f_{meß}: Ausgangsfrequenz der Signalerzeugungseinheit 40
- f_{ref}: Referenzfrequenz
- h: Höhe der Leiterbahnen 20, 25
- 1: Länge der Leiterbahnen 20, 25
- SiNO₂: Siliziumnitrit
- SiO₂: Siliziumdioxid

## Patentansprüche

1. Elektrische oder elektronische Schaltungsanordnung (100), aufweisend
- mindestens ein insbesondere schichtförmiges Trägersubstrat (10) aus halbleitendem oder isolierendem Material;
- mindestens eine durch mindestens zwei beabstandet zueinander auf dem Trägersubstrat (10) insbesondere lithographisch aufgebrachte Leiterbahnen (20, 25) gebildete integrierte Schaltung,
- mindestens eine sich zwischen den Leiterbahnen (20, 25) und/oder lateral zu den Leiterbahnen (20, 25) und/oder auf den Leiterbahnen (20, 25) befindliche, zum Schützen der integrierten Schaltung vor äußeren Einflüssen vorgesehene dielektrische Abdeckung (30; 35), insbesondere Isolierungsschicht und/oder Passivierungsschicht (30) und/oder weitere Schutzschicht (35), so dass die integrierte Schaltung einen spezifischen, durch die dielektrische Abdeckung (30; 35) bestimmten, insbesondere lateralen und/oder insbesondere parasitären Kapazitätswert (C) aufweist,
**dadurch gekennzeichnet,**
- **dass** an die Kontaktanschlüsse (22, 27) der integrierten Schaltung mindestens eine Signalerzeugungseinheit (40), insbesondere mindestens eine Oszillatoreinheit, angeschlossen ist, deren Ausgangsfrequenz (f_{meß}) im wesentlichen durch den spezifischen Kapazitätswert (C) bestimmt ist,
- **dass** der Signalerzeugungseinheit (40) mindestens eine erste, mit der Ausgangsfrequenz (f_{meß}) der Signalerzeugungseinheit (40) getaktete Zählereinheit (50) nachgeschaltet ist, in der nach einer vorgegebenen zeitlichen Zählperiode ein Istwert-Zählerstand ermittelbar ist,
- **dass** mindestens eine zweite, mit einer Referenzfrequenz (f_{ref}) getaktete Zählereinheit (55) vorgesehen ist, in der nach der vorgegebenen zeitlichen Zählperiode ein Sollwert-Zählerstand ermittelbar ist,
- **dass** der ersten Zählereinheit (50) und der zweiten Zählereinheit (55) mindestens eine Komparatoreinheit (60) zum Vergleichen des Istwert-Zählerstands mit dem Sollwert-Zählerstand nachgeschaltet ist, wobei die Funktionen der integrierten Schaltung bei Vorliegen einer beim Vergleichen des Istwert-Zählerstands mit dem Sollwert-Zählerstand auftretenden Fehlermeldung vorübergehend oder dauernd blockierbar und/oder sperrbar und/oder unterbrechbar sind.

2. Schaltungsanordnung (100) gemäß Anspruch 1,
**dadurch gekennzeichnet,**
**dass** die Leiterbahnen (20, 25) zumindest abschnittsweise parallel zueinander und/oder meanderartig ineinandergreifend angeordnet sind.

3. Schaltungsanordnung (100) gemäß Anspruch 1 oder 2,
**dadurch gekennzeichnet,**
**dass** der Abstand (d) der Leiterbahnen (20, 25) zueinander im Mikrometerbereich liegt.

4. Schaltungsanordnung (100) gemäß mindestens einem der Ansprüche 1 bis 3,
**dadurch gekennzeichnet,**
**dass** das Material der dielektrischen Abdeckung (30; 35) aus Epoxidharz oder Siliziumnitrit (SiNO₂) oder Siliziumdioxid (SiO₂) oder anderen in der Halbleiterfertigung verwendeten Isolatorschichten besteht.

5. Schaltungsanordnung (100) gemäß mindestens einem der Ansprüche 1 bis 4,
**dadurch gekennzeichnet,**
**dass** das Material der dielektrischen Abdeckung (30; 35) auch lichtundurchlässig ausgebildet ist.

6. Schaltungsanordnung (100) gemäß mindestens einem der Ansprüche 1 bis 5,
**dadurch gekennzeichnet,**
**dass** die Signalerzeugungseinheit (40)
- mindestens einen Schwingkreis aus mindestens einer kapazitiven Einheit, insbesondere Kondensator, und aus mindestens einer resistiven Einheit, insbesondere Widerstand, und/oder
- mindestens einen Schwingkreis aus mindestens einer kapazitiven Einheit, insbesondere Kondensator, und aus mindestens einer induktiven Einheit, insbesondere Spule,
aufweist.

7. Schaltungsanordnung (100) gemäß mindestens einem der Ansprüche 1 bis 6,
**dadurch gekennzeichnet,**
**dass** durch die erste Zählereinheit (50), durch die zweite Zählereinheit (55) und durch die Komparatoreinheit (60) mindestens eine Auswerteeinheit (70), insbesondere mindestens eine differentielle Auswerteeinheit, gebildet ist.

8. Schaltungsanordnung (100) gemäß Anspruch 7,
**dadurch gekennzeichnet,**
**dass** die Auswerteeinheit (70) zum Feststellen einer durch ein zumindest partielles Entfernen der dielektrischen Abdeckung (30; 35) bedingten Änderung des spezifischen Kapazitätswerts (C) ausgelegt ist.

9. Schaltungsanordnung (100) gemäß Anspruch 7 oder 8,
**dadurch gekennzeichnet,**
**dass** die Auswerteeinheit (70) die Fehlermeldung generiert, wenn der Istwert vom Sollbereich abweicht.

10. Schaltungsanordnung (100) gemäß mindestens einem der Ansprüche 1 bis 9,
**dadurch gekennzeichnet,**
**dass** die erste Zählereinheit (50) und/oder die zweite Zählereinheit (55) auf digitaler Basis ausgebildet sind.

11. Karte, insbesondere Chipkarte oder Smart Card, aufweisend mindestens eine elektrische oder elektronische Schaltungsanordnung (100) gemäß mindestens einem der Ansprüche 1 bis 10.

12. Verfahren zum Schützen einer gemäß dem Oberbegriff des Anspruchs 1 ausgebildeten elektrischen oder elektronischen Schaltungsanordnung (100) vor Manipulation und/oder vor Mißbrauch,
**dadurch gekennzeichnet,**
- **dass** in mindestens einer Signalerzeugungseinheit (40), insbesondere in mindestens einer Oszillatoreinheit, eine durch den spezifischen Kapazitätswert (C) bestimmte Ausgangsfrequenz (f_{meß}) generiert wird;
- **dass** in mindestens einer ersten, mit der Ausgangsfrequenz (fmeß) der Signalerzeugungseinheit (40) getakteten Zählereinheit (50) nach einer vorgegebenen zeitlichen Zählperiode ein Istwert-Zählerstand ermittelt wird;
- **dass** in mindestens einer zweiten, mit einer Referenzfrequenz (fref) getakteten Zählereinheit (55) nach der vorgegebenen zeitlichen Zählperiode ein Sollwert-Zählerstand ermittelt wird;
- **dass** der Istwert-Zählerstand mit dem Sollwert-Zählerstand verglichen wird; und
- **dass** die Funktionen der integrierten Schaltung vorübergehend oder dauernd blokkiert und/oder gesperrt und/oder unterbrochen werden, wenn beim Vergleichen des Istwert-Zählerstands mit dem Sollwert-Zählerstand in mindestens einer Komparatoreinheit (60) eine Fehlermeldung auftritt.

13. Verfahren gemäß Anspruch 12,
**dadurch gekennzeichnet,**
**dass** mindestens eine durch die erste Zählereinheit (50), durch die zweite Zählereinheit (55) und durch die Komparatoreinheit (60) gebildete Auswerteeinheit (70) auf differentieller Basis arbeitet.

14. Verfahren gemäß Anspruch 13,
**dadurch gekennzeichnet,**
**dass** in der Auswerteeinheit (70) eine durch ein zumindest partielles Entfernen der dielektrischen Abdeckung (30; 35) bedingte Änderung des spezifischen Kapazitätswerts (C) festgestellt wird.

15. Verfahren gemäß Anspruch 14 oder 15,
**dadurch gekennzeichnet,**
**dass** in der Auswerteeinheit (70) die Fehlermeldung generiert wird, wenn der Istwert vom Sollbereich abweicht.
